# EUROPEAN PATENT APPLICATION

(11) **EP 4 796 997 A1**
(43) Date of publication of application: **26.08.2026**
(21) Application number: 25158986.7
(22) Date of filing: 20.02.2025
(51) Int. Cl.: G03F 7/00, H01B 7/04, H02G 11/00

(54) **FLEXIBLE SUPPLY STRUCTURE, POSITIONING MODULE AND LITHOGRAPHIC APPARATUS**

(71) Applicant: ASML Netherlands B.V., 5500 AH Veldhoven (NL)
(72) Inventor: NIKIPELOV, Andrey, 5500 AH Veldhoven (NL)
(74) Representative: ASML Netherlands B.V.

(57) **Abstract**

The invention provides a flexible supply structure configured to transfer supplies between a first object and a second object, wherein the first object is movable with respect to the second object,
wherein a first supply structure end of the flexible supply structure is connected to the first object and a second supply structure end of the flexible supply structure is connected to the second object,
wherein the flexible supply structure is configured to bend about a bending axis,
wherein the flexible supply structure comprises:
a cable slab having one or more supply hoses and/or supply cables, the cable slab having a cable slab width and a cable slab thickness,
at least one flexible shield element arranged along the cable slab to shield one or more sides of the cable slab, the shield element having a shield element thickness, wherein the shield element thickness is smaller than the cable slab thickness.

## Description

### FIELD

The present invention relates to a flexible supply structure and a positioning module comprising such flexible supply structure. The invention further relates to a lithographic apparatus comprising a positioning module.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus comprises movable objects that need supplies. These supplies for example comprise, fluids, for example cooling fluid or a vacuum (removal of gas), electricity, such as power supply or control and/or measurement signals, and/or optical signals. To transport these supplies towards/from the movable object, a flexible supply structure comprising supply hoses and/or supply cables may be provided to allow a flexible connection of the supply hoses and/or supply cables between the movable object and another object.

In an embodiment, the flexible supply structure may for example comprise a C-shaped cable slab formed by the supply hoses and/or supply cables. Typically the C-shaped cable slab is orientated in a direction of movement of the movable object, i.e. the supply hoses and/or supply cables each extend in a plane extending in the main direction of movement of the movable object and the vertical direction. When the moveable object moves in the direction of movement, i.e. a first horizontal direction, the C-shaped cable slab may roll back and forth.

Due to the bending of the cable slab, the cable slab may wear and particles may be released from the cable slab. The particles that are released due to wear of the supply hoses and/or the supply cables of the cable slab may lead to substrate defects in a lithographic process.

### SUMMARY

It is an object of the invention to provide an improved flexible supply structure. In particular, it is an object of the invention to provide a flexible supply structure that is less susceptible to wear and/or wherein release of particles due to wear of the cable slab is substantially reduced.

According to an aspect the invention there is provided a flexible supply structure configured to transfer supplies between a first object and a second object, wherein the first object is movable with respect to the second object,
wherein a first supply structure end of the flexible supply structure is connected to the first object and a second supply structure end of the flexible supply structure is connected to the second object,
wherein the flexible supply structure is configured to bend about a bending axis,
wherein the flexible supply structure comprises:
a cable slab having one or more supply hoses and/or supply cables, the cable slab having a cable slab width and a cable slab thickness,
at least one flexible shield element arranged along the cable slab to shield one or more sides of the cable slab, the shield element having a shield element thickness, wherein the shield element thickness is smaller than the cable slab thickness.

According to an aspect the invention there is provided a positioning module comprising:
a first object;
a second object, wherein the first object is movable with respect to the second object; and
a flexible supply structure according to any of the claims 1-22 to transfer supplies between the first object and the second object.

According to an aspect the invention there is provided a lithographic apparatus comprising the positioning module of claim 23.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a positioning module comprising a flexible supply structure according to a known embodiment;
- Figure 3 shows a side view of the flexible supply structure of the positioning module of Figure 2;
- Figure 4 depicts a positioning module comprising a flexible supply structure according to an embodiment of the invention;
- Figure 5 shows a side view of the flexible supply structure of the positioning module of Figure 4;
- Figure 6 shows a cross-section of the flexible supply structure of Figures 4 and 5;
- Figure 7 shows a cross-section of a first alternative embodiment of a flexible supply structure according to the invention;
- Figure 8 shows a cross-section of a second alternative embodiment of a flexible supply structure according to the invention; and
- Figure 9 shows a cross-section of a third alternative embodiment of a flexible supply structure according to the invention.

### DETAILED DESCRIPTION

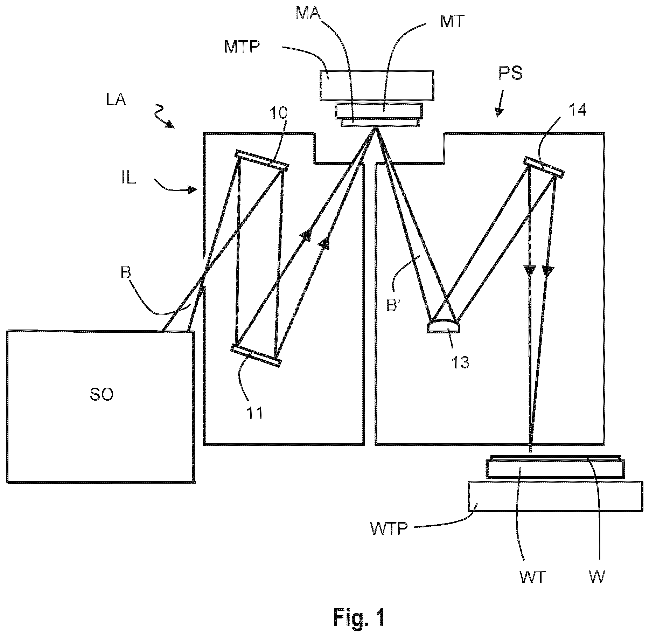

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

A substrate table positioning system WTP is provided to position the substrate table WT in a desired position. The substrate positioning system WTP comprises a position measurement system to measure a position of the substrate table WT and an actuation system to move the substrate table WT to a desired position. A patterning device support positioning system MTP is provided to position the support structure MT in a desired position. The patterning device support positioning system MTP also comprises a position measurement system to measure a position of the support structure MT and an actuation system to move the support structure MT to a desired position.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The lithographic process comprises a series of projection phases, in which the patterned EUV radiation beam B' is projected onto the substrate W (exposure phase) and/or in which the substrate W is being aligned with the patterned EUV radiation beam B' (alignment phase) and idle phases in which no patterned EUV radiation beam B' is projected onto the substrate W, or on a non-relevant part of the substrate W and positioning accuracy of the substrate W with respect to the patterned EUV radiation beam B' is less critical. During the projection phase the patterning device and the substrate may be moved in a scanning movement with a constant scanning velocity. The idle phase may be used to decelerate and (re)accelerate the patterning device MT and the substrate W to the desired scanning velocity and a desired alignment with respect to the EUV radiation beam B and the patterned EUV radiation beam B', respectively. The constant scanning velocity of the patterning device MA is typically different than the constant scanning velocity of the substrate W.

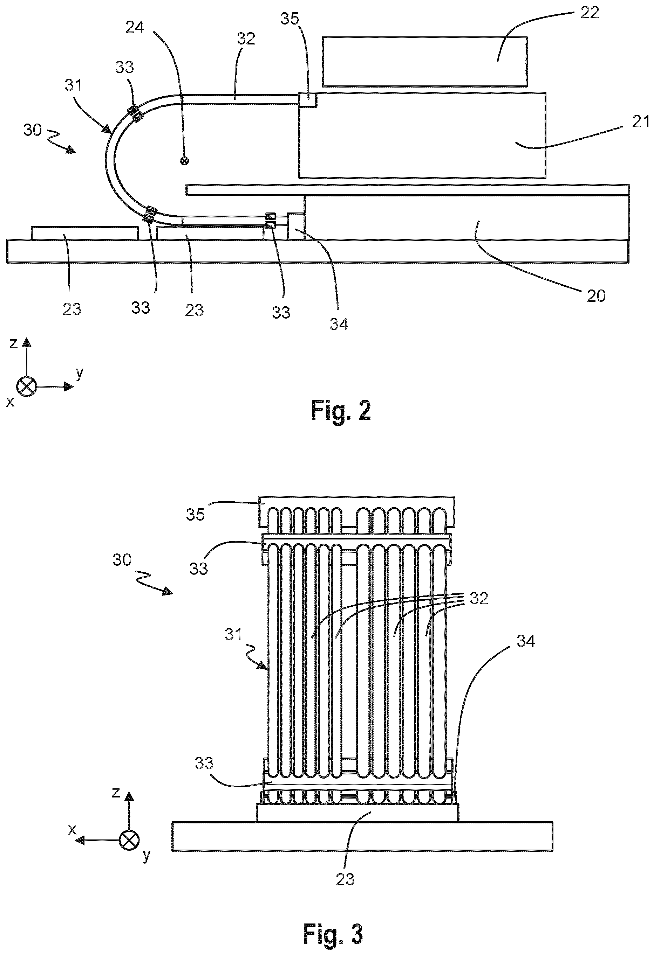

Figure 2 shows a known embodiment of a positioning module comprising a base frame 20, a first movable object 21, and a second movable object 22.

The first movable object 21 is supported on the base frame 20 and is movable with respect to the base frame 20 in a first horizontal direction, e.g. the y-direction. The second movable object 22 is supported on the first movable object 21 and is movable with respect to the first movable object 21 in a second horizontal direction, e.g. the x-direction. Actuators may be provided to exert actuation forces on the first movable object 21 and the second movable object 22 to move the first movable object 21 and the second movable object 22 towards a desired position.

The positioning module may be part of a substrate positioning system WTP arranged to position a substrate W, for example supported on the second movable object 22, in a desired position, as shown in Figure 1.

It may be desirable that supplies are exchanged between the base frame 20 and the first movable object 21. These supplies for example comprise, fluids, for example cooling fluid or a vacuum (removal of gas), electricity, such as power supply or control and measurement signals and/or optical signals.

The positioning module comprises a flexible supply structure 30 that extends between the base frame 20 and the first movable object 21 to exchange supplies between the base frame 20 and the first movable object 21. The supplies may be transported from the base frame 20 to the first movable object 21 and/or from the first movable object 21 to the base frame 20.

Figure 3 shows a side view of the flexible supply structure 30 of the positioning module of Figure 2, partially supported on one or more supports 23. The one or more supports 23 may for example be formed as support plates on which the supply hoses and/or supply cables 32 are mechanically supported. In addition or as an alternative, the flexible supply structure 30 can be self-supporting or be supported contactless. Contactless support may for example be magnetically or electrostatically, using magnets and/or electrodes.

The flexible supply structure 30 comprises a cable slab 31. The cable slab 31 comprises supply hoses and/or supply cables 32 extending between the base frame 20 and the first movable object 21, and clamp brackets 33 to clamp the supply hoses and/or supply cables 32 to form the cable slab 31. One end of the cable slab 31 is connected to a first manifold 34 mounted on the base frame 20 and a second opposite end of the cable slab 31 is connected to a second manifold 35 mounted on the first movable object 21. The first manifold 34 and the second manifold 35 may be any structure or device arranged to connect the supply hoses and/or supply cables 32 to the base frame 20 and the first movable object 21, respectively. The clamp brackets 33 may each comprise a pair of clamp strips between which the multiple supply hoses and supply cables 32 are clamped next to each other.

The cable slab 31 is shaped in a C-shape having a lower part, a middle part and an upper part. The C-shaped cable slab 31 is orientated in the direction of movement of the first movable object 21, i.e. the supply hoses and/or supply cables 32 each extend in a plane extending in the y-direction and z-direction. The flexible supply structure 30 is bent around a bending axis 24 extending in a bending direction in x-direction.

When the first moveable object 21 moves in the first horizontal direction, e.g. y-direction, the C-shaped cable slab 31 may roll back and forth, wherein a smaller or larger part of the cable slab may be supported by the one or more supports 23. During rolling back and forth of the cable slab 31, the bent part of the cable slab 31 will change in dependence of the relative position between the base frame 20 and the first movable object 21, i.e. another part of the cable slab 31 will bend at another location. As a result, the location of the bending axis 24 may also change due to a change in the relative position between the base frame 20 and the first movable object 21.

A further flexible supply structure (not shown) similar to the flexible supply structure 30 between the base frame 20 and the first movable object 21 may be provided between the first movable object 21 and the second movable object 22 to exchange supplies between the first movable object 21 and the second movable object 22. This further flexible supply structure 30 will typically be orientated in the second horizontal direction, e.g. x-direction. This means that the supply hoses and/or supply cables will extend in the plane extending in the x-direction and z-direction.

Although the flexible supply structure 30 provides for an efficient transfer of supplies between the base frame 20 and the first movable object 21, the bending of the cable slab 31 may result in wear of the supply hoses and/or the supply cables 32 of the cable slab 31. As a result of this wear, particles may be released from the supply hoses and/or the supply cables 32. The free particles may lead to substrate defects in a lithographic process. This is undesirable.

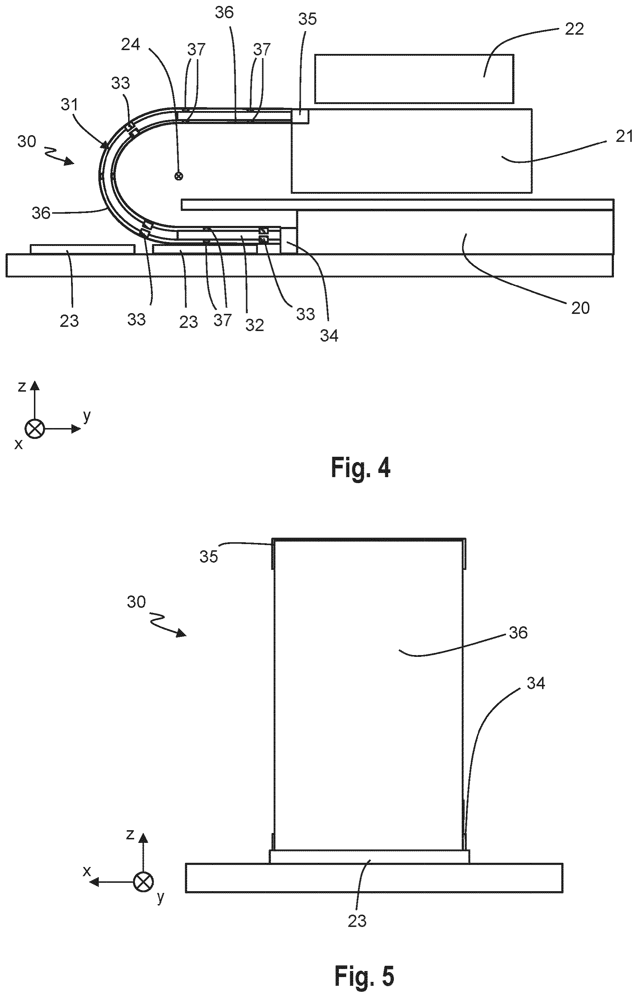

Figures 4 and 5 show an embodiment of a positioning module comprising a flexible supply structure 30 according to the invention. Generally, the configuration of the flexible supply structure 30 of Figures 4 and 5 corresponds to the configuration of the embodiment of Figures 2 and 3. Same or corresponding parts of the positioning module are indicated by the same reference numerals.

The positioning module comprises a flexible supply structure 30 configured to transfer supplies between the base frame 20 and the first movable object 21. A first supply structure end of the flexible supply structure 30 is connected to the base frame 20 at the first manifold 34 and a second supply structure end of the flexible supply structure 30 is connected to the first movable object 21 at the second manifold 35. The flexible supply structure 30 is configured to bend about a bending axis 24. As explained above, the location of this bending axis 24 may change in dependence of the relative position of the first movable object 21 with respect to the base frame 20, but the bending axis will always extend in x-direction.

The flexible supply structure 30 comprises a cable slab 31 having one or more supply hoses and/or supply cables 32.

In addition to the flexible supply structure 30 of Figures 2 and 3, the flexible supply structure 30 of Figures 4 and 5 comprises two flexible shield elements 36 arranged along the cable slab 31 to shield opposite sides of the cable slab 31. A first flexible shield element 36 is provided to shield a first side of the cable slab 31 and a second flexible shield element 36 is arranged to shield a second side of the cable slab 31.

The two shield elements 36 are each formed by a sheet, film or plate extending substantially parallel to the respective sides of the cable slab 31. As a result, the shield elements 36 extend substantially parallel to the bending axis 24. The shield elements 36 may be continuous or may be provided with slots, slits or other openings.

The shield elements 36 have a shield element thickness. This shield element thickness is smaller than a cable slab thickness of the cable slab 31. As a result of this smaller shield element thickness compared with the cable slab thickness, bending of the shield elements 36 results in less internal stresses in the material of the shield elements 36. As a consequence, the wear of the material in the shield elements 36 and the chance of particles being released from the shield elements 36 is also reduced.

In an embodiment, the cable slab thickness may be in the range of 1 mm to 20 mm, while the shield element thickness is in the range of 0.1 mm to 2 mm. In an embodiment, the shield element thickness is less than 30 %, for example less than 20% of the cable slab thickness. The shield element thickness may for example be in the range of 5 % to 15% of the cable slab thickness.

The material of the shield elements 36 may be configured to attract and/or retain particles released from the cable slab 31. Suitable materials to be used for the shield elements 36 are for example polymer films or polymer sheets. The shield elements may comprise integrated fibers, for example glass or carbon fibers or strands to increase resistance of the shield element to bending fatigue.

Generally, it may be undesired that the shield elements 36 contact the cable slab to avoid any release of particles from the cable slab 31 and/or the shield elements 36, in particular due to sliding contact between the cable slab 31 and the shield elements 36 . To avoid contact between the shield elements 36 and the cable slab 31, the shield elements 36 are spaced with a spacing distance from the cable slab 31. The spacing distance may for example be in the range 0.1 mm to 30 mm, such as in the range of 1 mm to 10 mm.

Spacer elements 37 are provided to hold the shield elements 36 at the spacing distance from the cable slab 31. The shield elements 36 may be sufficiently stiff to avoid contact between the shield elements 36 and the cable slab 31 at locations where no spacer elements 37 are provided. The spacer elements 37 may be compliant elements, such as springs, in particular film springs, to have a relatively flexible connection between the shield elements 36 and the cable slab 31. The spacer elements 37 may also be provided as elements that provide a contact-free spacing between the shield elements 36 and the cable slab 31, such as magnets or electrodes, to create a levitating force between the shield elements 36 and the cable slab 31.

The spacer elements 37 may be provided as separate elements or may be integrated with the respective shield element into a single element.

The spacer elements 37 may also be used to fix the shield elements 36 to the cable slab 31. The clamp brackets 33 may function as spacer elements or one or more spacer elements may be mounted on the clamp brackets 33.

In the embodiment of Figures 4 and 5, the shield elements 36 extend along a complete length of the cable slab 31 from the first manifold 34 to the second manifold 35. In alternative embodiments, one or both shield elements 36 may extend only along a part of the length of the cable slab 31, for example only the part of the length of the cable slab 31 that may bend during displacements of the first movable object 21 with respect to the base frame 20. In length direction of the cable slab 31 multiple shield elements 36 may be arranged at a single side of the cable slab 31

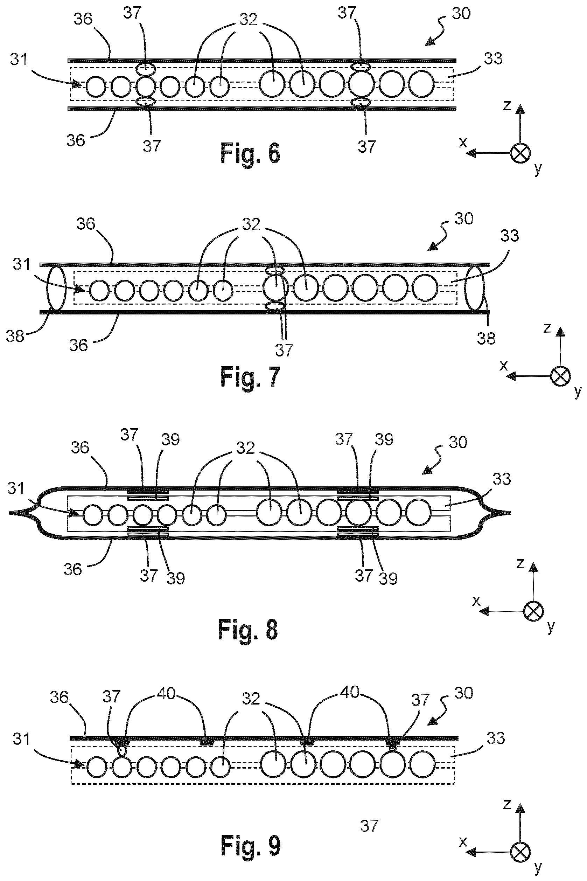

Figure 6 shows a cross-section of the flexible supply structure 30 of Figures 4 and 5 comprising the cable slab 31 and shield elements 36. The shield elements 36 are spaced from the cable slab 31 by spacer elements 37.

The shield elements 36 have a shield element width and the cable slab 31 has a cable slab width. In the shown embodiment the shield element width and cable slab width extend in x-direction and the shield element width and the cable slab width substantially correspond. This means that at the ends of the cable slab 31 in x-direction, no covering of the cable slab 31 is provided. However, since the material of the shield elements 36 may be configured to attract and/or retain particles released from the cable slab 31 and most of the surface of the cable slab 31 is covered by the shield elements 36, the release of particles from the flexible supply structure 30 may be substantially reduced compared to the flexible supply structure of the embodiment of Figures 2 and 3.

Figure 7 shows a cross-section of a first alternative embodiment of a flexible supply structure 30 with shield elements 36. In this embodiment, the shield element width of the shield elements 36 is substantially larger than the cable slab width of the cable slab 31 with the result that at both ends of the cable slab 31 (in x-direction) the shield element 36 extend further than the cable slab 31. This additional extension of the shield elements 36 with respect to the cable slab 31 provides an improved covering of the ends of the cable slab 31 and therewith improved attraction and/or retaining of particles released from the cable slab 31.

Shield element spacers 38 are arranged between the two shield elements 36 to hold the shield elements 36 at a shield element spacing distance from each other. The shield element spacers 38 may also be configured to connect the shield elements 36 to each other. Spacer elements 37 are provided to maintain the cable slab 31 positioned between the shield elements 36. The spacer elements 37 are also used to fix the shield elements 36 to the cable slab 31.

Figure 8 shows a cross-section of a second alternative embodiment of a flexible supply structure 30 with shield elements 36. In this embodiment, the shield elements 36 are connected to each other at their ends in width direction, e.g. x-direction, to form an enclosure of the cable slab 31. Particles released from the cable slab 31 are entrapped within the enclosure since the ends of the cable slab 31 in x-direction are covered by the shield elements 36.

Spacer elements 37 are provided in the form of magnets that cooperate with magnets 39 provided on the clamp bracket 33. The magnets of the spacer elements 37 and the magnets 39 have opposite magnetic fields such that they repel each other in order to create a spacing distance between the shield elements 36 and the cable slab 31. Since pairs of magnets are arranged at opposite sides of the cable slab 31, a balance in magnet forces is create to maintain the cable slab 31 in a fixed relative position between the shield elements 36.

Figure 9 shows a cross-section of a third alternative embodiment of a flexible supply structure 30 with a shield element 36. In this embodiment, only on one side of the cable slab 31 a shield element 36 is provided to cover this respective side of the cable slab 31. Covering only one side of the cable slab 31 may already have a positive effect on attracting and/or retaining particles released from the cable slab 31.

In an alternative embodiment, only one shield element 36 may be provided on the opposite side of the cable slab 31, e.g. at the lower side of the cable slab 31 instead of the upper side of the cable slab 31 as shown in Figure 9.

The shield element 36 comprises longitudinal stiffening elements 40, e.g. ribs, to increase the stiffness of the shield element 36. Spacer elements 37 are provided between the stiffening elements 40 and the cable slab 31 to fix the shield element 36 to the cable slab 31 and hold the shield element 36 at a desired spacing distance from the cable slab 31.

The stiffening elements 40 may be integrated in the shield element 36 and be made of the same material, for example by providing thickened parts in the shield element 36. The stiffening elements may also be provided as separate elements fixed to the shield element 36.

Any other way of providing stiffness in shield element 36 may also be used. The stiffness may be created in length direction and/or width direction, for example by ribs or other elongated elements extending in length direction, width direction or an angle therebetween, such as a diagonal direction. As a result of the separate or integrated stiffening elements 40, such as ribs, stiffness in one direction of the shield element 36, e.g. stiffness in length direction, may differ from stiffness of the shield element 36 in another direction, e.g. stiffness in width direction.

In Figures 6-9 four examples of a cross-section of a flexible supply structure 30 according to an embodiment of the invention are shown. The features described with respect to these embodiments may also be applied in other combinations.

Hereinabove, a flexible supply structure 30 is shown and described having a C-shaped configuration, wherein a lower part of the C-shaped configuration is supported by a support 23. In other embodiments, as an alternative of or in addition to the support 23 at the lower part of the flexible supply structure 30, there may also be provided support for the middle part and/or the upper part of the C-shaped configuration.

It may also be possible that the flexible supply structure 30 has other shapes or configurations, wherein supports 23 are used to support the flexible supply structure 30. In another embodiment, the flexible supply structure 30 may be self-supporting, such that there is no need to provide supports to support the flexible supply structure 30.

Hereinabove, a flexible supply structure 30 is described with respect to a first movable object 21 movably supported on a base frame 20, in particular in a positioning module of a lithographic apparatus. The flexible supply structure 30 may also be used in combination with any other movable object to exchange supplies between the movable object and another object.

In the embodiment described hereinabove, the first object, e.g. the first movable object 21, is linearly movable with respect to the second object, e.g. the base frame 20. In other embodiments of the invention, the flexible supply structure may be provided between a first object and a second object, wherein the first object is rotatable with respect to the second object or wherein the first object is linearly movable and rotatable with respect to the second object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Reference numerals

| | | | |
|---|---|---|---|
| SO | radiation source | LA | lithographic apparatus |
| B | EUV radiation beam | IL | illumination system |
| MT | patterning device support structure | MA | patterning device |
| PS | projection system | WT | substrate table |
| W | substrate | WTP | substrate table positioning system |
| MTP | patterning device support positioning system | | |
| 10 | facetted field mirror device | 11 | facetted pupil mirror device. |
| B' | patterned EUV radiation beam | 13, 14 | mirrors |

| | | | |
|---|---|---|---|
| 20 | base frame | 21 | first movable object |
| 22 | second movable object | 23 | support |
| 24 | bending axis | 30 | flexible supply structure |
| 31 | cable slab | 32 | supply hoses and/or supply cables |
| 33 | clamp bracket | 34 | first manifold |
| 35 | second manifold | 36 | shield element |
| 37 | spacer element | 38 | shield element spacer |
| 39 | magnet | 40 | stiffening element |

## Claims

1. A flexible supply structure configured to transfer supplies between a first object and a second object, wherein the first object is movable with respect to the second object,
wherein a first supply structure end of the flexible supply structure is connected to the first object and a second supply structure end of the flexible supply structure is connected to the second object,
wherein the flexible supply structure is configured to bend about a bending axis,
wherein the flexible supply structure comprises:
a cable slab having one or more supply hoses and/or supply cables, the cable slab having a cable slab width and a cable slab thickness,
at least one flexible shield element arranged along the cable slab to shield one or more sides of the cable slab, the shield element having a shield element thickness, wherein the shield element thickness is smaller than the cable slab thickness.

2. The flexible supply structure of claim 1, wherein the at least one flexible shield element is spaced with a spacing distance from the cable slab.

3. The flexible structure of claim 2, wherein the spacing distance is in the range 0.1 mm to 30 mm.

4. The flexible supply structure of any of the claims 1-3, wherein the at least one flexible shield element is a sheet, film or plate extending substantially parallel to the bending axis.

5. The flexible supply structure of any of the claims 1-4, wherein the at least one flexible shield element has a shield element width, wherein the shield element width is larger than the cable slab width.

6. The flexible supply structure of any of the claims 1-5, wherein the flexible supply structure comprises spacer elements to hold the at least one flexible shield element spaced from the cable slab.

7. The flexible supply structure of claim 6, wherein the spacer elements are used to fix the at least one flexible shield element to the cable slab.

8. The flexible supply structure of claim 6 or 7, wherein the spacer elements and the at least one flexible shield element are integrated into a single element.

9. The flexible supply structure of any of the claims 6-8, wherein the spacer elements are configured to prevent contact between the at least one flexible shield element and the cable slab.

10. The flexible supply structure of any of the claims 6-9, wherein the spacer elements comprise compliant elements, magnets and/or electrodes.

11. The flexible supply structure of any of the claims 1-10, wherein the at least one flexible shield element is made of a material that attracts and/or retains particles released from the cable slab.

12. The flexible supply structure of any of the claims 1-11, wherein the one or more supply hoses and/or supply cables are arranged next to each other in a direction parallel to the bending direction.

13. The flexible supply structure of any of the claims 1-12, wherein a first flexible shield element is provided to shield a first side of the cable slab and a second flexible shield element is arranged to shield a second side of the cable slab, the second side being opposite to the first side.

14. The flexible supply structure of claim 13, wherein the flexible supply structure comprises shield element spacers arranged between the first flexible shield element and the second flexible shield element.

15. The flexible supply structure of any of the claims 1-14, wherein the cable slab thickness is in the range of 1 mm to 20 mm and the shield element thickness is in the range of 0.1 mm to 2 mm.

16. The flexible supply structure of any of the claims 1-15, wherein the shield element thickness is maximally 25% of the cable slab thickness.

17. The flexible supply structure of any of the claims 1-16, wherein a stiffness of the at least one flexible shield element is configured to avoid contact between the at least one shield element and the cable slab.

18. The flexible supply structure of the claim 1-17, wherein the at least one shield element comprises one or more stiffening elements to increase stiffness of the shield element.

19. The flexible supply structure of the claim 1-18, wherein a stiffness of the at least one shield element is different in width direction than in length direction.

20. The flexible supply structure of any of the claims 1-14,wherein the first object is translatable and/or rotatable with respect to the second object.

21. The flexible supply structure of any of the claims 1-20, wherein the supplies comprise gas, liquid, electricity, control and/or measurement signals, and/or optical signals.

22. The flexible supply structure of any of the claims 1-21, wherein the at least one shield element has a shield element length, wherein the shield element length is equal or smaller than a length of the cable slab.

23. A positioning module comprising:
a first object;
a second object, wherein the first object is movable with respect to the second object; and
a flexible supply structure according to any of the preceding claims to transfer supplies between the first object and the second object.

24. A lithographic apparatus comprising the positioning module of claim 23.

25. The lithographic apparatus of claim 24, wherein the first object and/or the second object are part of a substrate support or a patterning device support.
